# EUROPEAN PATENT SPECIFICATION

(11) **EP 1 178 888 B1**
(45) Date of publication and mention of the grant of the patent: **08.08.2007**
(21) Application number: 00920257.3
(22) Date of filing: 20.04.2000
(51) Int. Cl.: B41J 2/045, B41J 2/05

(54) **ACTUATOR CONTROL IN A MICRO ELECTRO-MECHANICAL LIQUID EJECTION DEVICE**
BETÄTIGERSTEUERVORRICHTUNG IN EINER MIKROELEKTROMECHANISCHEN VORRICHTUNG ZUM AUSSTOSSEN VON FLÜSSIGKEIT
COMMANDE D'ACTIONNEUR DANS UN DISPOSITIF D'EJECTION DE LIQUIDE MECANIQUE MICROELECTRIQUE

(30) Priority: 22.04.1999 AU PP993099
(43) Date of publication of application: 13.02.2002
(73) Proprietor: Silverbrook Research Pty. Limited, Balmain, NSW 2041 (AU)
(72) Inventor: SILVERBROOK, Kia, Silverbrook Research Pty Ltd, Balmain, New South Wales 2041 (AU)
(74) Representative: Ferreccio, Rinaldo
(86) International application number: PCT/AU2000/000339
(87) International publication number: WO 2000/064678

(56) References cited:
- WO-A-99/03680
- WO-A-99/03681
- US-A- 3 683 212
- US-A- 3 857 049

## Description

### Field of the Invention

The present invention relates to a method of controlling an actuator in micro electro-mechanical device. The invention is herein described in the context of an ink jet printer but it will be appreciated that the invention does have application to other micro electro-mechanical devices such as micro electro-mechanical pumps.

### Background of the Invention

Micro electro-mechanical devices are becoming increasingly well known and normally are constructed by the employment of semi-conductor fabrication techniques. For a review of micromechanical devices consideration may be given to the article "The Broad Sweep of Integrated Micro Systems" by S. Tom Picraux and Paul J. McWhorter published December 1998 in IEEE Spectrum at pages 24 to 33.

One type of micro electro-mechanical device is the inkjet printing device from which ink is ejected by way of an ink ejection nozzle chamber. Many forms of the ink jet printing device are known. For a survey of the field, reference is made to an article by J Moore, ''Non-Impact Printing: Introduction and Historical Perspective", Output Hard Copy Devices, Editors R Dubeck and S Sherr, pages 207-220 (1988).

A new form of ink jet printing has recently been developed by the present applicant, this being referred to as Micro Electro Mechanical Inkjet (MEMJET) technology. In one embodiment of the MEMJET technology, ink is ejected from an ink ejection nozzle chamber by a paddle or plunger which is moved toward an ejection nozzle of the chamber by an electro-mechanical actuator for ejecting drops of ink from the ejection nozzle chamber.

WO 99/03681 to the present applicant describes a number of different arrangements of such ink ejection nozzle chambers and etectro-mochanical actuators. Methods of operating and controlling the ejection of ink are also described.

U.S. Patent No. 3,857,049 to Zoltan describes a piezoelectric-type actuator for an ink ejection system and a method of ejecting ink by pulsed driving of the actuator. The present invention relates to a method of controlling an actuator of a type that is used in the MEMJET technology and other micro electro-mechanical devices.

### Summary of the Invention

The invention may be broadly defined as providing a method of controlling liquid movement to and from a liquid ejection device having a nozzle chamber, a liquid ejection aperture in the nozzle chamber and a movable element located within the chamber for displacing liquid through the ejection aperture. The method comprises the steps of actuating the movable element by thermal actuation so that it moves from a quiescent first position to a liquid ejecting second position with a first average velocity, and deactuating the movable element so that it returns from the second position to the first position with a second average velocity, the deactuation being controlled so that the second average velocity is lower than the first average velocity.

The movable element is displaced from the first to the second position by application of a primary energising pulse, and displacement of the movable element from the second position to the first position is retarded by application of at least one secondary energising pulse having a duration that is less than that of the first energising pulse.

The invention may further be defined as providing a liquid ejection device comprising a nozzle chamber, a liquid ejection aperture in the nozzle chamber, a movable element located within the chamber fur displacing liquid through the ejection aperture, and a thermal actuator for effecting displacement of the movable element from a quiescent first position to a liquid ejecting second position within the chamber. Also, means are provided for controlling actuation of the thermal actuator in a manner to move the movable element from the first position to the second position with a first average velocity and for controlling deactuation of the thermal actuator in a manner to return the movable element from the second position to the first position at a second average velocity lower than the first average velocity.

The movable element in the liquid ejection device preferably comprises a paddle which, when moved from the first position to the second position, uncovers an opening through which the liquid passes for subsequent ejection from the aperture. Also the liquid ejection device preferably includes a series of baffles adjacent the opening to inhibit the back flow of liquid through the opening during movement of the paddle from the second position to the first position.

### Brief Description of the Drawings

Notwithstanding any other forms which may fall within the scope of the present invention, a preferred form of the invention will now be described, by way of example only, with reference to the accompanying drawings in which:
Fig. 1 illustrates a sectional view of a portion of an ink ejecting nozzle chamber of an ink jet printer;
Fig. 1A illustrates a portion of the nozzle chamber of Fig. 1 with a paddle of the nozzle chamber shown in a quiescent first position;
Fig. 2 illustrates a portion of the nozzle chamber of Fig. 1 with a paddle of the nozzle chamber shown in an ink ejecting second position;
Fig. 3 illustrates a portion of the nozzle chamber of Fig. 1 with a paddle of the nozzle chamber shown returning to the quiescent first position;
Fig. 4 is a drive voltage diagram applicable to voltage drive applied to a paddle actuator of the nozzle chamber;
Fig. 5 shows a graph of displacement of the paddle actuator against time resulting from application of the drive voltage shown in Fig. 4;
Fig. 6 is a drive voltage diagram applicable to voltage drive applied to the paddle actuator in accordance with a preferred form of the present invention;
Fig. 7 shows a graph of displacement of the paddle actuator against time resulting from application of the drive voltage shown in Fig. 6.

### Description of Preferred Embodiment

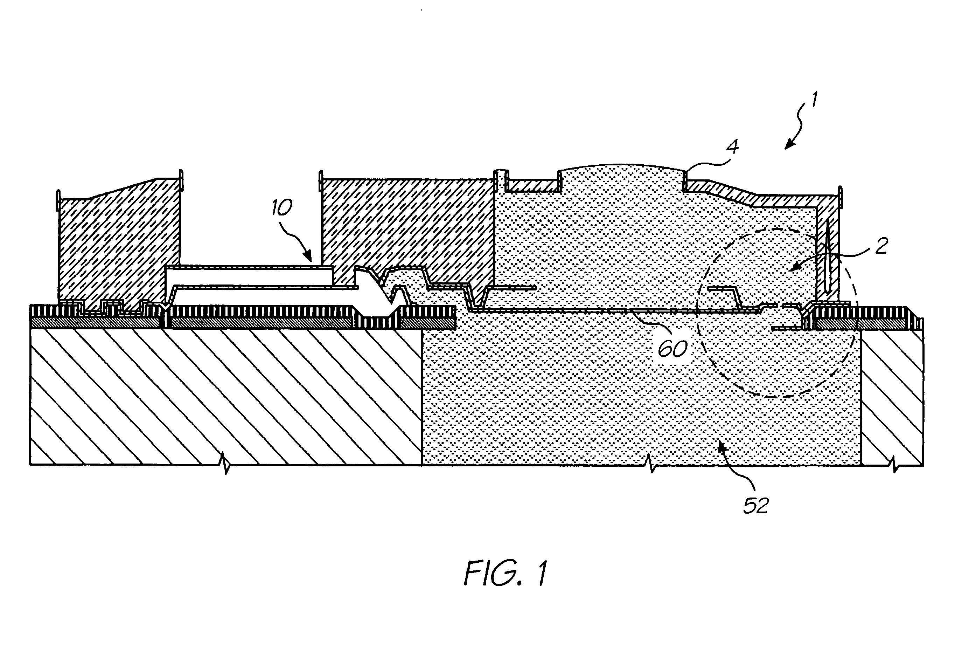

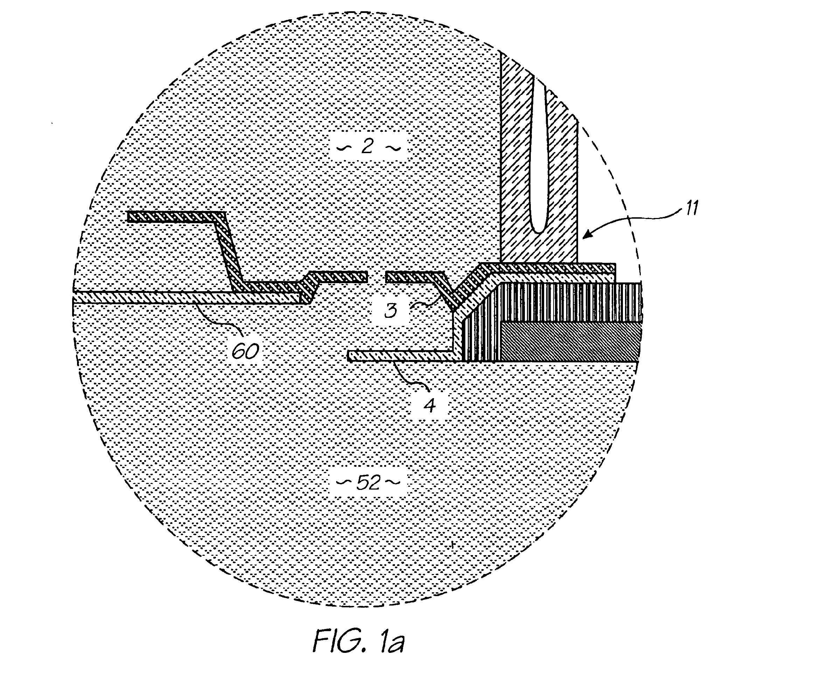

Fig. 1 shows a device 1 for the ejection of ink. The device 1 comprises a nozzle chamber 2 and a paddle 60 located within the nozzle chamber 2 for ejecting ink from the chamber 2 through aperture 4. The paddle 60 is connected to a thermal actuator 10 which is employed to move the paddle 60 toward the aperture 4 for the ejection of ink and back into a quiescent first position.

Figure 1A illustrates a detail of the device shown in Fig.1. The nozzle chamber 2 has formed in a wall structure 11 thereof a nozzle chamber rim 3 and second rim 4. The paddle 60 is shown in the first position.

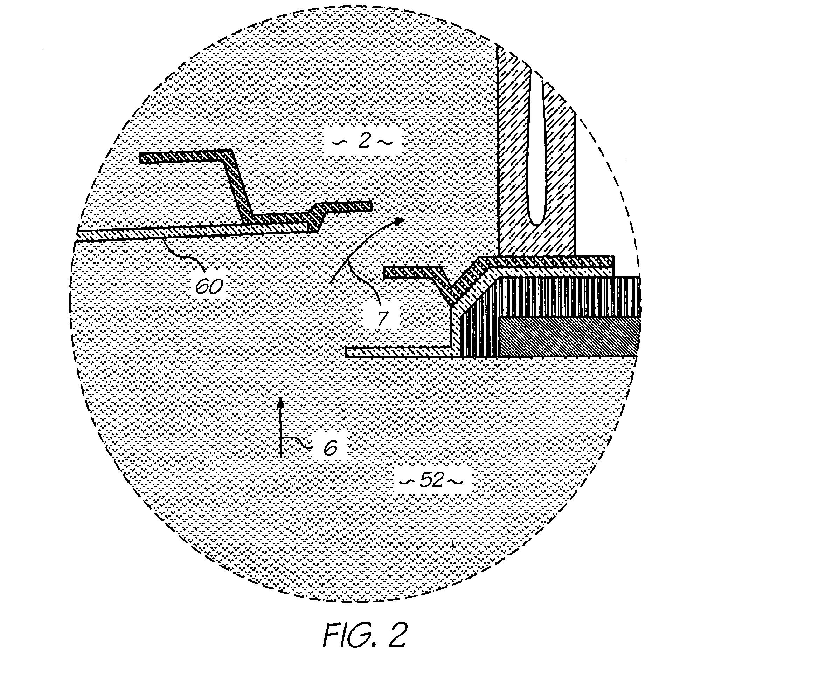

Upon actuation of the actuator 10, the paddle 60 is caused to move upwardly as illustrated in Fig. 2. This results in a rapid upward flow of ink behind the paddle 60 from the ink supply channel 52 as indicated by arrow 6. As an ink drop is ejected from the ink ejection nozzle, a corresponding amount of ink also flows into the nozzle chamber as indicated by arrow 7. This ink replenishes the nozzle chamber 2.

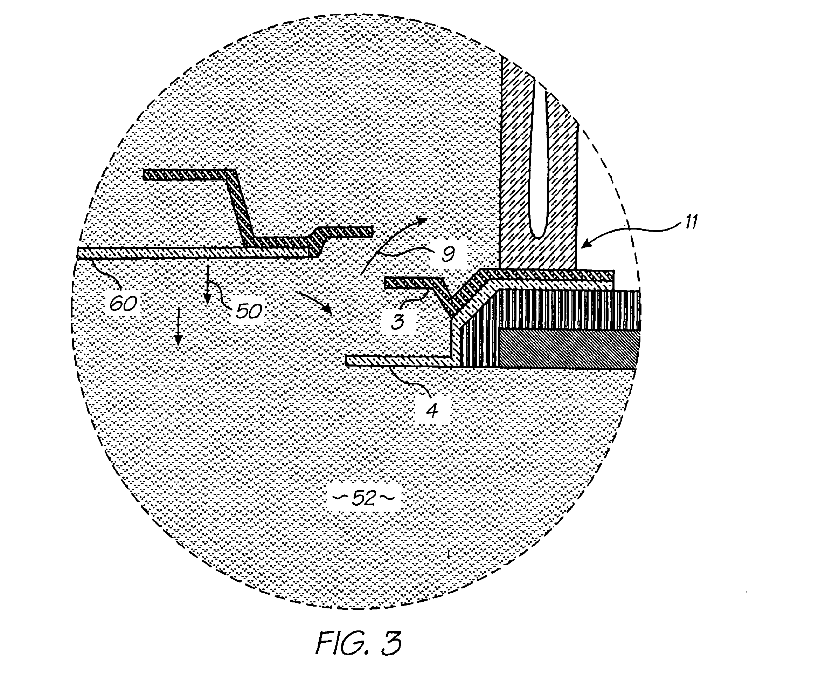

Thereafter, the actuator is deactuated and, as illustrated in Fig. 3 the paddle 60 begins to move back to its quiescent position as indicated by arrow 50 .

Because the wall structure 11 of the nozzle chamber comprises the series of rims 3 and 4, the back flow of liquid into the ink supply channel 52 is hindered. This facilitates the forward flow of ink into the nozzle chamber, as indicated by arrow 9, to replenish the ejected ink. Also, in order to further assist the forward flow of the ink in the direction of the arrow 9, the paddle 60 is moved back in a controlled manner as described below.

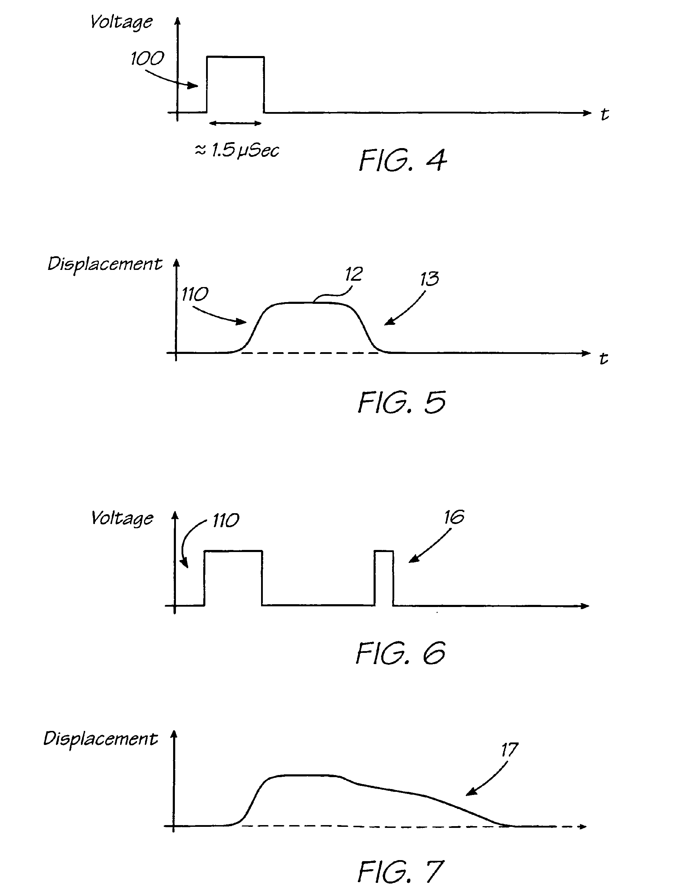

Fig. 4 illustrates the form of a voltage pulse that might be employed to drive electrical current through the actuator 10. As is described in International Patent Application No. PCT/AU00/00095 filed on February 11, 2000 by the present applicant, the electrical current induces heating in and, as a consequence, bending of the actuator 10 to move the paddle 60 from the first to the second position. The voltage and, as a consequence, current pulse 100 as shown in Fig. 4 for driving the actuator 10 would normally occupy a 1.5 microsecond period. The displacement of the actuator and, hence, the paddle rises sharply to a maximum level indicated by numeral 12 in Fig. 5 and, thereafter, falls at substantially the same rate, as indicated by numeral 13 in Fig. 5 following expiration of the voltage pulse period. The average velocity of displacement of the paddle 60 in moving from the second position to the first position is substantially equal to the average velocity of displacement of the paddle from the first position to the second position.

In the preferred embodiment of the present invention, the return rate of displacement of the actuator 10 and, hence, the paddle 60 is slowed and this is achieved by applying a further drive voltage (and hence current) pulse 16 of shorter duration to the actuator 10. This has the effect of extending the displacement time for or, in other words, reducing the average velocity of the return of the paddle 60 from the second to the first position, as indicated by numeral 17 in Fig. 7.

It will be understood that the displacement plot as shown in Fig. 7 may be further extended to meet specific requirements by generating a series of the short duration pulses 16 following generation of the relatively longer pulse 110.

The slow return of the paddle 60 to its quiescent first position (relative to the more rapid movement of the paddle 60 toward the second position) permits an increased flow of the ink into the nozzle chamber, this resulting from a reduced back-pressure being applied to the ink flowing into the chamber from the inlet channel 52.

Whilst the embodiment of the invention has been described above with reference to an ink ejection system that utilises a thermal actuator 10, other types of actuators might alternatively be employed. For example, a piezo-electric actuator or a shape-memory alloy actuator may be employed as an alternative to the thermal actuator. Under these circumstances the actuators may be controlled in a different manner from that which is described above but still with the purpose of increasing the displacement time during the closing motion and, hence, varying the velocity of movement in the respective directions.

Other variations and modifications may be made in respect of the invention as above described without departing from the scope of the invention as defined in the appended claims.

## Claims

1. A method of controlling liquid movement to and from a liquid ejection device (1) having a nozzle chamber (2), a liquid ejection aperture (4) in the nozzle chamber and a movable element 60 located within the chamber for displacing liquid through the ejection aperture; the method comprising the steps of:
a) actuating the movable element 60 by thermal actuation so that it moves from a quiescent first position to a liquid ejecting second position with a first average velocity; and
b) deactuating the movable element 60 so that it returns from the second position to the first position with a second average velocity;
**characterized in that** in step a) the actuation is caused by application of a primary energising pulse (100) and in step b) the return of the movable element is retarded by application of at least one secondary energising pulse (16) having a duration that is less than that of the first energising pulse such that the second average velocity is lower than the first average velocity.

2. A liquid ejection device (1) comprising a nozzle chamber (2), a liquid ejection aperture (4) in the nozzle chamber, and a movable element (60) located within the chamber for displacing liquid through the ejection aperture, and a thermal actuator (10) for effecting displacement of the movable element from a quiescent first position to a liquid ejecting second position within the chamber,
**characterized by** father comprising means arranged to control the actuation of the thermal actuator (10) with a primary energising pulse (100) so as to move the movable element (60) from the first position to the second position with a first average velocity and arranged to control the actuation of the thermal actuator (10) with at least one secondary energising pulse (16) having a duration that is less than that of the first energising pulse to cause return of the movable element (60) from the second position to the first position at a second average velocity lower than the first average velocity.

3. The liquid ejection device as claimed in claim 2 wherein the movable element comprises a paddle (60) which, when moving from the first position to the second position, uncovers an opening (52) through which the liquid passes for subsequent ejection from the aperture (4).

4. The liquid ejection device as claimed in claim 3 wherein the thermal actuator (10) is coupled to the paddle (60) and is actuated with passage of electrical current to effect displacement of the paddle (60).

5. The liquid ejection device as claimed in claim 4 wherein the thermal actuator (10) is caused to bend and so displace the paddle (60) from the first position to the second position with application of a current pulse for a first duration, wherein the thermal actuator (10) is permitted to recover following expiration of the first duration and wherein recovery of the thermal actuator (10) is delayed by application of a second current pulse for a duration shorter than that of the first current pulse.

6. The liquid ejection device as claimed in claim 3 wherein a series of baffles (3,4) is provided adjacent the opening (52) to inhibit the back flow of liquid through the opening (52) during movement of the paddle (60) from the second position to the first position.

## Patentansprüche

1. Verfahren zur Steuerung der Flüssigkeitsbewegung zu und von einer Flüssigkeitsausstoßvorrichtung (1), die mit einer Düsenkammer (2), einer Flüssigkeitsausstoßöffnung (4) in der Düsenkammer (2) und einem beweglichen Element (60) versehen ist, das innerhalb der Kammer zum Verlagern von Flüssigkeit durch die Ausstoßöffnung angeordnet ist, wobei das Verfahren die Schritte umfasst:
a) In Betrieb setzen des beweglichen Elements (60) durch thermische Betätigung derart, dass es sich von einer ersten Ruhestellung zu einer Flüssigkeit ausstoßenden zweiten Stellung mit einer ersten Durchschnittsgeschwindigkeit bewegt und
b) außer Betrieb setzen des beweglichen Elements (60) derart, dass es von der zweiten Stellung zu der ersten Stellung mit einer zweiten Durchschnittsgeschwindigkeit zurückkehrt;
**dadurch gekennzeichnet, dass** in dem Schritt a) das in Betrieb setzen bewirkt wird durch Anwendung eines ersten erregenden Impulses (100) und in dem Schritt b) die Rückkehr des beweglichen Elementes (10) verzögert wird durch Anwendung mindestens eines zweiten erregenden Impulses (16), der eine Dauer aufweist, die kleiner ist als die des ersten erregenden Impulses, so dass die zweite Durchschnittsgeschwindigkeit niedriger ist als die erste Durchschnittsgeschwindigkeit.

2. Flüssigkeitsausstoßvorrichtung (1) umfassend eine Düsenkammer (2), eine Flüssigkeitsausstoßöffnung (4) in der Düsenkammer und ein bewegliches Element (60), das innerhalb der Kammer zum Verlagern der Flüssigkeit durch die Ausstoßöffnung angeordnet ist, und einen thermischen Betätiger (10) zur Bewirkung der Verlagerung des beweglichen Elements von einer ersten Ruhestellung zu einer Flüssigkeit ausstoßenden zweiten Stellung innerhalb der Kammer,
**dadurch gekennzeichnet, dass** es ferner Mittel umfasst, die zum Steuern die Inbetriebsetzung des thermischen Betätigers (10) mit einem ersten erregenden Impuls (100) derart vorgesehen sind, um das bewegliche Element (60) von der ersten Stellung zu der zweiten Stellung mit einer ersten Durchschnittsgeschwindigkeit zu bewegen, und zur Steuerung der Außerbetriebsetzung des thermischen Betätigers (10) mit mindestens einem zweiten erregenden Impuls (16) angeordnet sind, der eine Dauer aufweist, die geringer ist als die geringer ist als die des ersten erregenden Im pulses, um die Rückkehr des beweglichen Elements (60) von der zweiten Stellung zu der ersten Stellung mit einer zweiten Durchschnittsgeschwindigkeit zu bewirken, die niedriger ist als die erste Durchschnittsgeschwindigkeit.

3. Flüssigkeitsausstoßvorrichtung nach Anspruch 2, in der das bewegliche Element einen Flügel (60) umfasst, der, wenn er sich von der ersten Stellung zu der zweiten Stellung bewegt, eine Öffnung (52), durch welche Flüssigkeit zum nachfolgenden Ausstoß durch die Öffnung (4) fließt, frei gibt.

4. Flüssigkeitsausstoßvorrichtung nach Anspruch 3, in der der thermische Betätiger (10) mit dem Flügel (60) gekoppelt ist und durch Fluss eines elektrischen Stroms zur Bewirkung der Verlagerung des Flügels (60) betätigt wird.

5. Flüssigkeitsausstoßvorrichtung nach Anspruch 4, in der der thermische Betätiger (10) durch Anwendung eines Stromimpulses für eine erste Dauer zum Biegen und somit zur Verlagerung des Flügels (60) von der ersten Stellung zu der zweiten Stellung bewirkt wird, wobei dem thermischen Betätiger (10) die Rückstellung nach Ablauf der ersten Dauer erlaubt wird und wobei die Rückkehr des thermischen Betätigers (10) durch Anwendung eines zweiten Stromimpulses einer kürzeren Dauer, als derjenigen des ersten Stromimpulses, verzögert wird.

6. Flüssigkeitsausstoßvorrichtung nach Anspruch 3, in der eine Reihe von Staublechen (3, 4) benachbart der Öffnung (52) vorgesehen sind, um den Rückfluss der Flüssigkeit durch die Öffnung (52) während der Bewegung des Flügels (60) von der zweiten Stellung zu der ersten Stellung zu verhindern.

## Revendications

1. Un procédé pour contrôler le mouvement de va et vient d'un liquide dans un dispositif d'éjection de liquide (1) ayant une chambre de tuyère (2), une ouverture pour l'éjection du liquide (4) dans la chambre de tuyère et un élément mobile (60) situé à l'intérieur de la chambre pour déplacer le liquide à travers l'ouverture pour l'éjection; le procédé comprenant les étapes suivantes :
a) l'actionnement de l'élément mobile (60) par actionnement thermique de manière à ce qu'il se déplace d'une première position de repos jusqu'à à une seconde position d'éjection du liquide avec une première vitesse moyenne ; et
b) la désactivation de l'élément mobile 60 de manière à ce qu'il retourne de la seconde position à la première position avec une seconde vitesse moyenne ;
**caractérisé en ce qu'**à l'étape a) l'actionnement est causé par l'application d'une pulsation énergisante primaire (100) et à l'étape b) le retour de l'élément mobile est retardé par l'application d'au moins une pulsation énergisante secondaire (16) ayant une durée qui est inférieure à celle de la première pulsation énergisante de manière à ce que la seconde vitesse moyenne soit inférieure à la première vitesse moyenne.

2. Un dispositif d'éjection de liquide (1) comprenant une chambre de tuyère (2), une ouverture pour l'éjection du liquide (4) dans la chambre de tuyère, et un élément mobile (60) situé dans la chambre pour déplacer le liquide à travers l'ouverture pour l'éjection, et un actionneur thermique (10) pour effectuer le déplacement de l'élément mobile d'une première position de repos jusqu'à à une seconde position d'éjection du liquide dans la chambre,
**caractérisé en ce qu'**il comprend en outre des moyens qui sont prévus pour contrôler l'actionnement de l'actionneur thermique (10) avec une pulsation énergisante primaire (100) dans le but de déplacer l'élément mobile (60) d'une première position jusqu'à une seconde position avec une première vitesse moyenne, et qui sont prévus pour contrôler la désactivation de l'actionneur thermique (10) avec au moins une pulsation énergisante secondaire (16) ayant une durée qui est inférieure à celle de la première pulsation énergisante pour causer le retour de l'élément mobile (60) de la seconde position à la première position à une seconde vitesse moyenne inférieure à la première vitesse moyenne.

3. Le dispositif d'éjection de liquide selon la revendication 2 dans lequel l'élément mobile comprend une pale (60) qui, lorsqu'elle se déplace de la première position à la seconde position, libère une cavité (52) à travers laquelle le liquide passe pour l'éjection subséquente par l'ouverture (4).

4. Le dispositif d'éjection de liquide selon la revendication 3 dans lequel l'actionneur thermique (10) est couplé à la pale (60) et est actionné par le passage d'un courant électrique pour effectuer le déplacement de la pale (60).

5. Le dispositif d'éjection de liquide selon la revendication 4 dans lequel l'actionneur thermique (10) permet de courber et ainsi de déplacer la pale (60) de la première position jusqu'à la seconde position par l'application d'une pulsation de courant pendant une première durée, dans lequel l'actionneur thermique (10) est autorisé à se rétablir suite à l'expiration de la première durée, et dans lequel le rétablissement de l'actionneur thermique (10) est retardé par l'application d'une seconde pulsation de courant pour une durée plus courte que celle de la première pulsation de courant.

6. Le dispositif d'éjection de liquide selon la revendication 3 dans lequel une série de chicanes (3,4) est ménagée à proximité de la cavité (52) pour empêcher le flux de retour du liquide à travers la cavité (52) au cours du mouvement de la pale (60) de la seconde position à la première position.
